(19) Europäisches Patentamt
European Patent Office
Office européen des brevets

(11) **EP 2 139 139 A1**

(12) **EUROPEAN PATENT APPLICATION**

(43) Date of publication:
**30.12.2009 Bulletin 2009/53**

(51) Int Cl.:
***H04L 1/00*** (2006.01)

(21) Application number: **08305343.9**

(22) Date of filing: **27.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Thomson Licensing**
**92100 Boulogne-Billancourt (FR)**

(72) Inventors:
 • **Zhou, Wei**
  **100086, BEIJING (CN)**
 • **Zou, Li**
  **100088, BEIJING (CN)**

(74) Representative: **Ruellan-Lemonnier, Brigitte**
**Thomson multimedia**
**Patent Department**
**46 Quai A. Le Gallo**
**92648 Boulogne Cedex (FR)**

(54) **Method and apparatus for non binary low density parity check coding**

(57)     Methods and apparatus for non-binary, low density parity check coding are disclosed. The inventive methods comprise encoding the signal with a low density parity check code, rotating a component of the coded signal, delaying the rotated component, and interleaving symbols associated with the rotated and delayed components of the signal.

Figure 2 BER performance of the proposed solution systems with different labeling over different rotation angles at SNR = 12.8 dB, Rayleigh channel

Fig. 3

**Description**

FIELD OF THE INVENTION

The present invention relates generally to methods and apparatus for non-binary low density parity check (LDPC) coding. More specifically, the present invention relates to non-binary LDPC for QAM modulated signals.

BACKGROUND OF THE INVENTION

For digital terrestrial video broadcasting transmission, the problem of overcoming the effect of channel fading is essential. One technique to reduce channel fade is to rotate the signal constellation and delay the Q component of the signal. This tends to achieve better performance. However, such techniques are limited to binary channel codes, such as binary low density parity check codes (LDPC) and Turbo codes. To improve transmission, modern digital television systems and digital video broadcasting transmission systems mainly adopt non-binary modulation and therefore these techniques cannot be employed to reduce channel fading. In order to further increase the capacity against the effect of fading channel, signal space diversity can be introduced into coded modulation. For example, the BICM (bit interleaving coded modulation) Turbo/LDPC couple with signal space diversity has at most 0.7dB gain than the classical BICM Turbo/ LDPC.

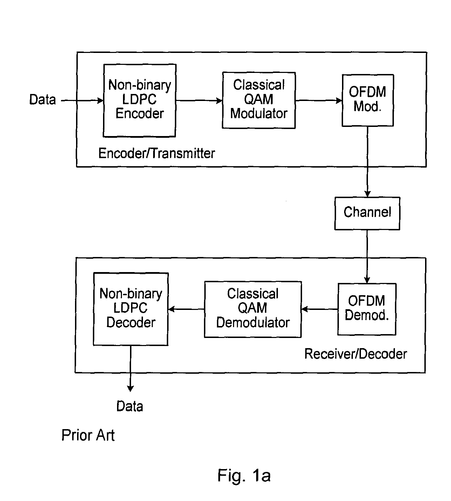

Figure 1a is a block diagram of a prior art transmission and receiving system which produces a Rayleigh channel that experiences channel fading. As is conventional, such a system in the encoder/transmitter head end comprises a non-binary LDPC encoder, a classical QAM modulator, and an OFDM modulator which mixes the signal and outputs it to the channel. At the receivers/decoders, the channel is OFDM demodulated to strip the carrier, QAM demodulated, and decoded by a non-binary LDPC decoder. Other complex data blocks are typically also required such as bit interleaver/ deinterleavers as well as iterative decoding loops.

At the output of the fading channel, the transmitted QAM constellation signal is subject to the same fading coefficient on both component axes. For severe fading, it will lead to irreversible loss in information for both component axes. So it can be observed that at high signal-to-noise ratios, the slope of a bit-error-ration (BER) curve decreases. To further lower the BER, the diversity order should be increased.

When a binary LDPC is utilized in a non-binary, memory-less modulation scheme, conversion of modulation symbol likelihoods into code bit probabilities is needed before decoding. Similarly, in the transmitter bitstreams should be mapped into symbols. Standard information models show that a significant loss in performance may be caused by symbol-to-bit and bit-to-symbol conversions. To achieve better performance in this arena, binary extrinsic probabilities generated by the LDPC decoder are fedback to the demapping block in order to close the iterative detection/decoding loop. In the context of constellation rotation and the delay of the Q component of the signal, when binary channel codes are adopted, an iterative loop between the channel decoder and the demapper is typically used to achieve acceptable performance. However, the use of an iterative loop leads to large data delays, which in turn decrease s the Quality of Service (QoS) of the channel.

It is known that when the code alphabet is matched to the modulation alphabet, the channel likelihoods are directly processed by the decoder without any information loss, and there is no need to iterate between demodulation and decoding. For example, a non-binary LDPC can match the modulation alphabet well when the number of constellation points in the signal set does not exceed the number of elements in the field over which the code is defined. Non-binary LDPC codes also have better performance at small or moderate block lengths. Binary LDPC codes are now well recognized as capacity approaching codes for various types of channels when the size of the codeword tends to infinity. However there are several issues for which the binary LDPC codes show their limits such as coded modulations and/or coding for small or moderate block lengths. Fortunately, non-binary LDPC codes can be a good alternative in these issues. So in band-limited communication systems, non-binary LDPC codes are good candidate for small or moderate block lengths.

The transmission fading channel may be modeled as a Rayleigh fading channel with coherent detection. Therefore, the received discrete time baseband complex signal can be written as:

$r_t = p_t x_t + n_t$, where $p_t$ is the Rayleigh distributed fading coefficient with $E(p_t^2) = 1$, and $n_t$ is a complex white Gaussi an noise with spectral density $N_0/2$ in each component axis. Perfect channel state information (CSI) is assumed so that $p_t$ is perfectly estimated and available at the receiver.

The inventors have recognized a long-felt need in the art for non-binary LDPC modulation schemes that are computationally efficient and which have a high QoS. These coding techniques should employ LDPC decoders which achieve high performance without significant information loss. Such needs have not heretofore been achieved in the art.

## SUMMARY OF THE INVENTION

The aforementioned problems are solved, and long-felt needs met, by methods and systems provided in accordance with the present invention. In a preferred embodiment, the methods and systems comprise receiving a signal comprising a Q component and an I component, delaying at least one of said Q component and said I component, rotating a signal constellation comprised of symbols derived from the Q and I components, and decoding the signal.

## BRIEF DESCRIPTION OF THE DRAWINGS

Figure 1a is a block diagram of a prior art transmission and receiving system.
Figure 1b is a block diagram of a preferred transmission system of the present invention utilizing LDPC decoders.
Figure 1c is a block diagram of a further preferred transmission system of the present invention utilizing LDPC decoders.
Figure 2 is a flow chart of an encoding and modulation method provided in accordance with the present invention.
Figure 3 is a graph of a simulation of BER results using techniques of the present invention for different types of labeling.
Figure 4 is a graph of a 16 QAM constellation derived in accordance with the present invention.
Figure 5 is a graph of bit error rate against signal to noise ratio of a constellation which has had the techniques of the present invention applied to it and the same constellation without the use of the inventive techniques.

## DETAILED DESCRIPTION OF THE PREFERRED EMBODIMENTS

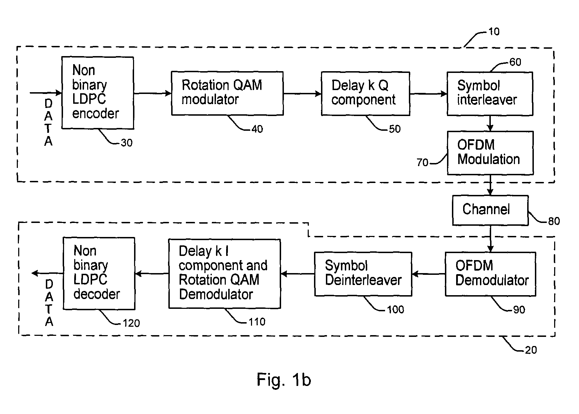

Referring now to the drawings wherein like reference numerals refer to like elements, Figure 1b is an exemplary transmission system employing elements and techniques of the present invention. The system preferably comprises an encoder head end 10 and a receiver 20. The encoder head end 10 is typically employed to receive terrestrial video signals and process them for transmission and/or broadcast according to the particular modulation format that is peculiar to the system. In a preferred embodiment, the QAM modulation scheme is preferred. However, it will be recognized by those skilled in the art that other modulation schemes may also employ the inventive techniques and systems. For example, QPSK, VSB, and other DVB-type modulation schemes are readily usable with the present techniques, and all are intended to be within the scope of the present invention. The invention will be described below with respect to a QAM modulation technique.

In a preferred embodiment, the inventive systems are designed with one symbol interleaver non-binary LDPC coded modulation couple with signal space diversity. In this configuration, the number of constellation points in the signal set should not exceed the number of elements in the field over which the non-binary LDPC codes are defined, which ensures that the channel likelihoods can be directly processed by the decoder without any information loss.

As is know by those skilled in the art, it is often useful to describe QAM techniques and symbol constellations according to Galois Field (GF) arithmetic field theory. The GF(q) field theory allows conceptual construction of constellation points in a signal over which an LDPC code is defined. As will be described below, the present invention will be described with respect to a 4QAM modulated signal which corresponds to at least a GF(4) space, and which can be expanded to, for example, GF(16),GF(64) or GF(256) constellations. In addition, the invention can be readily described according to a 164QAM modulated signal which corresponds to LDPC codes constructed in GF(16) and GF(256) constellations. For 64QAM modulated signals, GF(64) constellations are available, and for 256QAM modulated signals, GF(256) constellations are provided.

For non-binary LDPC coded modulation each element in one non-binary LDPC code word, as opposed to binary LDPC, is defined in GF(q) (q>1), and each element in GF(q) corresponds to each constellation point. The system of Figure 1b will produce such constellations in accordance with the present invention. Preferably, the number of constellation points in the QAM signal set should not exceed the number of elements in the field over which the non-binary LDPC codes are defined, so it does not require any iterative processing between the QAM demodulator and the LDPC decoder. This is possible since the QAM demodulator produces the prior probabilities for each GF(q) symbols that can be used directly for non-binary LDPC decoding over GF(q). This is in contrast with a binary LDPC coded system for higher order modulations where iterative processing between the QAM demodulator and the LDPC decoder is required for optimal performance, such as BICM-ID.

For each block of received signals r, the QAM demodulator computes the probability that the transmitted constellation symbol corresponds to some non-binary element $\beta \in$ GF(q). This is done through the computation of either the log-likelihood-ratio vector (LLRV) over GF(q) or the probability vector over GF(q). It is desirable to employ the probability vector (PV) over GF(q) in the QAM demodulator. The related formula is easy to extend into LLRV. Let {0,

$\alpha_1, ..., \alpha_{q-1}\}$ denote all the elements in GF(q). The probability vector over GF(q) is defined as: $P = \{p_0, p_1, ..., p_{q-1}\}$ where $p_i = P(\beta = \alpha_i)$. Here, $P(\beta = \alpha_i)$ denotes the probability that the transmitted GF(q) symbol $\beta$ equals $\alpha_i$. At the output of the maximum a posteriori (MAP) detector, the *i+1*-th component of the PV can be accounted by:

$$P(\beta = \alpha_i) = u_i \cdot \exp(-(r_t - p_t s_i)^2/(2\sigma^2)) \quad (1)$$

Here, $s_i$ is the constellation point which corresponds to the GF(q) symbol $\alpha_i$, and $u_i$ is the normalize factor.

Then, these initial probability vectors over GF(q) will output into non-binary LDPC decoder for BP decoding.

The encoder head end 10 more preferably comprises an LDPC encoder 30, which still more preferably is a non-binary LDPC encoder. Coupled to the encoder 30 is a rotation QAM modulator 40 which rotates the symbol constellation according to a particular percentage in the complex plane to achieve better performance of the transmission of the modulated signal. Use of the rotation modulator 40 eliminates the need for an iterative detection/decoding loop, thereby enhancing performance and reducing the computational complexity of the methods of the present invention.

In accordance with an important aspect of the invention, the rotated signal constellation is fed to a delay Q component block 50 which is adapted to delay the Q component of the constellation by an amount, k, which further enhances the signal quality and improves the performance of the system especially since the iterative loop has been eliminated. The delayed, rotated signal is then input to a conventional symbol interleaver 60 and modulated by a conventional OFDM modulator 70 which functions as a local oscillator. This modulated signal is then output onto the channel 80 to be broadcast to the desired receivers 20 in the transmission system.

Once the channel 80 is broadcast, the appropriate receivers 20 of the present invention will receive the signal on the channel for further processing. The receivers 20 may be set-top boxes, television receivers, or other processing units that are adapted to receive, decode and demodulate signals provided in accordance with the present invention.

Preferably, receivers 20 comprise an OFDM demodulator 90 which demodulates the signal and removes it from the carrier. A symbol deinterleaver 100 conventionally deinterleaves the signal to provide a deinterleaved constellation. It is then desired to input the deinterleaved signal constellation to block 120 which is adapted to rotate the I component of the signal an amount, k, to match it to the rotated Q component of the original signal, as well as to rotate the QAM constellation back to the original position for QAM demodulation. This signal is then input to a LDPC, non-binary decoder 130 for decoding and output to the ultimate user of the signal. The main purpose of these modifications is to increase the diversity order of the coded modulation of Fig. 1b by making the I and Q channels fade independently.

To ensure that the I and Q components fade independently; space signal diversity can be introduced. The space signal diversity gain can be obtained, due to the rotation, by inserting an interleaver between I and Q channels. In practice, this interleaver can be reduced to a delay of the quadrature component of the signal with respect to its in-phase component. The value of the delay is chosen according to the channel memory to make I and Q channels fade independently. Meantime, the symbol interleaver 60 can be added after that, which can implement frequency diversity. Thus, the present invention has the advantage of doubling the diversity order; a result which has not heretofore been achieved in the art.

In accordance with the invention, the computation of the probability vector over GF(q) depends on metrics from two different time signals.

$$P(\beta = \alpha_i) = u_i \cdot \exp\left(\frac{-\left(\left(r_t^I - p_{t-k}s_i^I\right)^2 + \left(r_t^Q - p_t s_i^Q\right)^2\right)}{2\sigma^2}\right) \quad (2)$$

Here, $p_{t-k}$ and $p_t$ are the Rayleigh distributed fading coefficient of the *t-k* th times and *t* th times. Also, $\sigma^2$ is the noise variance, $u_i$ is the normalize factor and $s_i$ is still the constellation point which corresponds to the GF(q) symbol $\alpha_i$. It should be noted that $r_t^I$ and $r_t^Q$ is the signal after the I component of the initial received signal has been delayed by the k times interval.

Advantageously, the architecture exemplified in Figure 1b does not require a bit interleaver as compared to a binary channel coded signal. In contrast, only a symbol deinterleaver is used to reduce the correlation in a fading channel. This result has not heretofore been achieved in the art and greatly reduces the complexity of the system, the cost of the components involved, and the computational overhead associated with a binary coded channel. Moreover, the angle of the rotation of the QAM constellation derived from the system of Figure 1b advantageously ensures that the minimum distance of a single axis in the constellation is obtained.

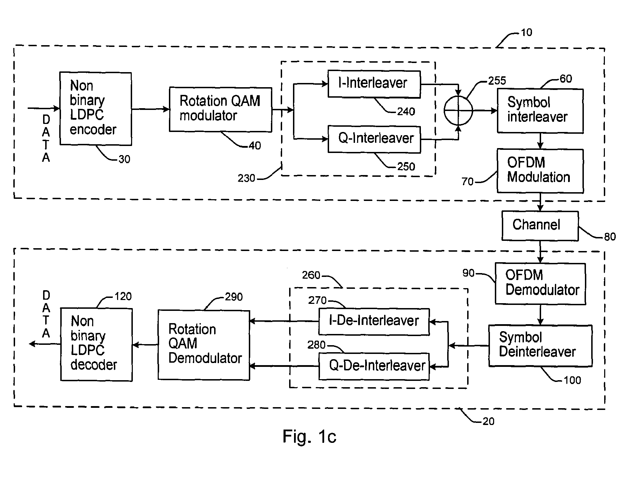

An alternative embodiment of transmission and receiving systems of the present invention is shown in Figure 1c. The components of the system of Figure 1c are similar to those of Figure 1b with the following differences. In order to provide the proper amount of delay to the Q component in the transmitter 10, block 50 is replace with an IQ interleaver 230. The IQ interleaver 230 interleaves the symbols in the I and Q components with an I-interleaver block 240 and a Q interleaver block 250. The interleaved I and Q components are summed by summer 255 for input to the symbol deinterleaver 60. This provides a desired level of signal delay to the constellation.

Similarly, on the receiver side 20, blocks 100 and 110 are replace by an IQ deinterleaver block 260 coupled to a QAM rotation block 290. The IQ deinterleaver block 260 comprises an I symbol deinterleaver 270 and a Q symbol deinterleaver 280, and further receives the deinterleaved constellation from the symbol deinterleaver 100. The deinterleaved I and Q components are input to the QAM rotation demodulator block 290 to rotate the constellation axes to the desired orientation for further decoding by the non-binary LDPC decoder block 120.

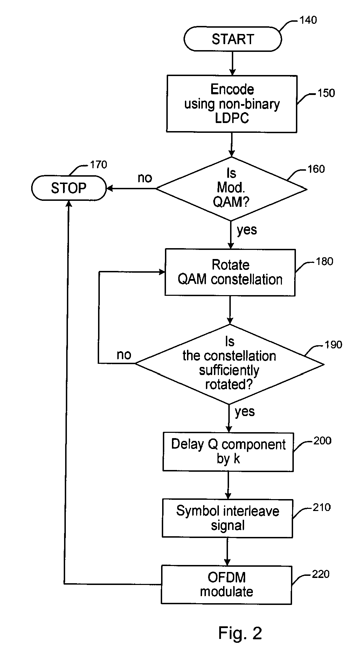

Figure 2 is an exemplary flow chart of a preferred method of encoding a channel in accordance with the present invention. It will be appreciated by those skilled in the art that the reverse procedure is generally used to decode the channel by receivers 20. Encoding starts at step 140 and at step 150 the signal is coded using preferably a non-binary LDPC encoder. When a QAM modulation scheme is to be used for the particular transmission system, it will be appreciated that at step 160 it is determined whether the modulation format is QAM. If not, then the system stops at 170, and another procedure may be applied to achieve the non-binary LDPC channel coding of the present invention. A detector (not shown) is thus preferably employed to determine the modulation format, and it will be further appreciated that any modulation format is thus usable in accordance with the present invention.

If the QAM modulation has been detected at step 160, then at step 180, the constellation comprising symbols associated with the signal is rotated a preferred amount to ensure efficient transmission so as to minimize loss, and preserve symbol integrity. It then is preferably determined at step 190 whether the constellation has been rotated a sufficient amount to ensure efficient signal transmission. It will be appreciated by those skilled in the art that the amount of rotation will be determined by the particular needs of the system. The amount of rotation is thus a design choice to fit the system's specifications. If the amount of rotation is not sufficient, then the method returns to step 180 wherein the constellation is rotated further and a new rotation angle can be applied to the constellation. If the amount of rotation is sufficient, the method proceeds to step 200 wherein the Q component is delayed by a time k to introduce a delay to the signal. The desired amount of delay is also a design choice which should be adapted to achieve optimum results for signal transmission and coding. Any amount of delay is allowable and potentially beneficial to the modulated, coded signal, and those skilled in the art will understand that a delay commensurate with system requirements is preferable. Alternatively at step 200 the Q and I components may be interleaved similar to the embodiment shown in Figure 1c.

Referring again to Figure 2, once the proper amount of delay is introduced into the system, symbol interleaving can occur at step 210 to achieve the proper form of coded signal. OFDM modulation is then imposed on the signal at step 220, and the coded signal is then output to the channel. It has been observed that a best rotation angle for binary channel codes is $\pi/8$ for a fading channel. However, this angle is not suitable for non-binary channel codes.

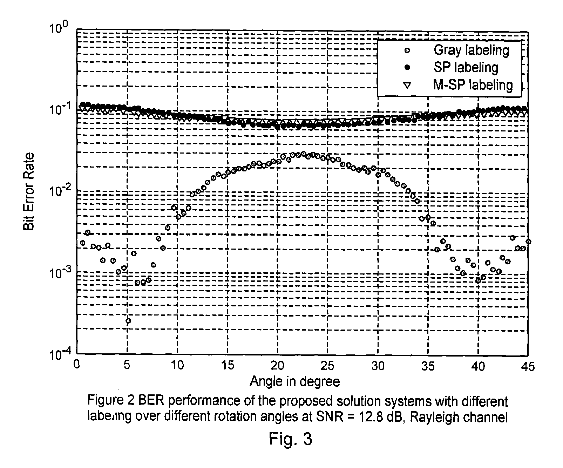

The effect of the constellation rotation for non-binary LDPC codes can be visualized by fixing the SNR value and observing a performance parameter, e.g., BER. Referring to Figure 3 the BER as a function of various rotation angles for 16 QAM modulations at SNR=12.8dB is shown. The channel model is preferably a Rayleigh channel which is generally known from the DVB-T specification. Figure 3 shows that the system performance is dependent upon the choice of the rotation angle. The simulation shows that the best performance happens at 7.5° and 22.5° for Gray and Set Partitioning labeling, respectively.

Labeling is another important factor for space signal diversity and is related to the decoding method. Most labeling schemes have the same minimum Euclidean distance between subsets of $x_i^0$ ($x_i^0$ means the constellation signal in which the $i$-th bit is 0) and $x_i^1$ ($x_i^1$ means the constellation signal in which the $i$-th bit is 1), but a different number of nearest neighbors. Therefore, for conventional BICM, Gray labeling has been considered to be optimal due to the smallest number of nearest neighbors.

For BICM-ID decoding, with perfect knowledge of all other bits, $2^m$-QAM modulation is translated to binary modulation selected from m possible sets of binary modulation. Iterative decoding of BICM not only increases the inter-subset Euclidean distance, but reduces a number of nearest neighbors to one as well. This leads to significant improvement over both AWGN and fading channel. Gray labeling is not the preferred choice since the minimum distance between subsets is not increased. Set-partitioning (SP) or so called "modified set-partitioning" (MSP) is optimal as compared to Gray labeling.

For non-binary LDPC, the decoding method is performed at the symbol level. Therefore, the factors, the minimum Euclidean distance between different symbols and the number of nearest symbol neighbors, have an influence on the error performance. Unless the bits composing one symbol are interleaved in non-binary LDPC decoding, the Gray labeling is the best choice. The simulation results shown in Figure 3 also shows that based on symbol BP decoding, Gray labeling has the best error performance.

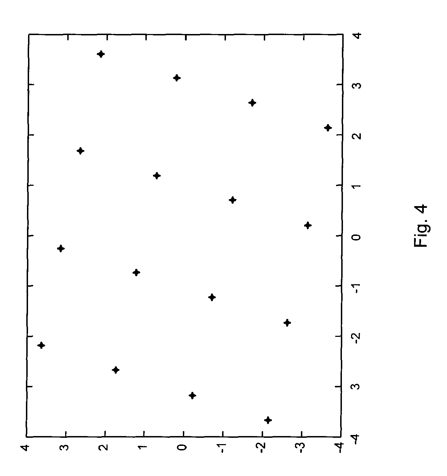

Figure 4 is a graph showing an exemplary 16QAM constellation achievable in accordance with techniques, methods and systems of the present invention. The invention produces an even and homogeneous distribution of constellation points for the system. Furthermore, the invention ensures that for the new coded modulation, the code alphabet matches well to the modulation alphabet when the number of constellation points in the signal set does not exceed the number of elements in the field over which the non binary LDPC code is defined. This result has not heretofore been achieved in the art.

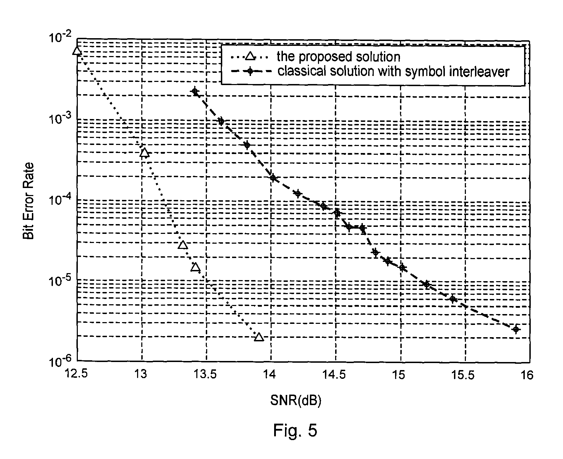

Figure 5 compares the performance of the inventive non-binary system using non-binary LDPC codes over GF (16). The channel model includes Rayleigh and AWGN channel in DVB-T. The rotation angle is 7.5° and labeling adopts Gray labeling. The code length is 1704 GF(16) symbol which represents 1704*4=6816 bits, and the code rate is ¾. The decoding algorithm of the non-binary code is implemented by BP decoding. The subcarrier number is 2K, and the guard interval is ¼.

Compared to binary LDPC using space signal diversity in high order QAM, the gain between the proposed solution and the original non binary LDPC coded modulation is larger. As Figure 5 shows, the gain is about 2dB gain at BER $10^{-6}$. The large gain is achieved since the output of the fading channel with added space signal diversity exists and both the independent I and Q channel represents the full transmitting of information separately. Since the channel likelihoods from the demodulator can be directly processed by the decoder without any information loss due to the use of the non-binary channel code, the space diversity can be utilized more effectively with the present invention than that which occurs in binary channel coded modulation. Therefore, a large gain can be achieved.

The present invention describes a new coded modulation transmission scheme using non-binary LDPC and rotation constellation and delay Q axis component. The inventive techniques employ a new scheme which combines non-binary LDPC with rotation constellation and delay Q component technology that achieves very good performance in Rayleigh channels and further reduces data delays. Moreover, the 2-Dimention demapper for rotation constellation can also help the requirement for the probability of each non-binary element of a non-binary LDPC code word, which is a key input for the non-binary LDPC decoder.

By properly choosing the LDPC over GF (q) (q>2) as the component code, this type of code can achieve better performance than binary LDPC code with shorter block size. By properly choosing the order of non-binary LDPC in the new coded modulation, it is ensured that the code alphabet matches we II to the modulation alphabet. This achieves better performance without the use of an iterative loop between the demapper and decoder. Moreover, by properly choosing the combination between the non-binary LDPC and rotation constellation, the probability of each non-binary element of the non-binary LDPC code word, which is a key input for non binary LDPC decoder, can be directly achieved from the 2-dimention demapper of the rotation constellation.

There has thus been described certain preferred embodiments of methods and apparatus for non-binary LDPC coding provided in accordance with the present invention. While preferred embodiments have been described and disclosed, it will be appreciated by those skilled in the art that modification are within the true spirit and scope of the present invention. The appended claims are intended to cover all such modifications.

**Claims**

1. A method of processing a coded signal comprising the steps of:

   receiving a signal comprising a Q component and an I component;
   delaying at least one of said Q component and said I component;
   rotating a signal constellation comprised of symbols derived from the Q and I components; and
   decoding the signal.

2. The method recited in claim 1, further comprising the step of symbol deinterleaving the symbols.

3. The method recited in claim 2, wherein the delaying step comprises the step of delaying the I component of the signal an amount, k.

4. The method recited in claim 2, wherein the delaying step comprises deinterleaving the I and Q components of the signal.

5. The method recited in claim 3, wherein the decoding step comprises decoding according to a low density parity check.

6. The method recited in claim 5, wherein the low density parity check is a non-binary low density parity check.

7. A receiver for implementing the method according to anyone of claims 1 to 6.

8. A method of coding a signal comprising the steps of:

    encoding the signal with a low density parity check code;
    rotating a component of the coded signal;
    delaying the rotated component; and
    interleaving symbols associated with the delayed, rotated and encoded signal.

9. The method recited in claim 8, wherein the low density parity check code comprises a non-binary low density parity check code.

10. The method recited in claim 9, wherein the signal is a QAM signal

11. The method recited in claim 10, wherein the rotating step comprises the step of rotating the QAM signal.

12. The method recited in claim 11, wherein the delaying step comprises the step of delaying a Q component of the signal an amount, k.

13. The method recited in claim 11, wherein the delaying step comprises the step of interleaving an I and Q component of the signal.

14. The method recited in claim 12, further comprising the step of OFDM modulating the coded, rotated, delayed signal for output to a channel.

Encoder/Transmitter

Data → Non-binary LDPC Encoder → Classical QAM Modulator → OFDM Mod.

Channel

OFDM Demod. → Classical QAM Demodulator → Non-binary LDPC Decoder

Receiver/Decoder

Data

Prior Art

Fig. 1a

Non binary LDPC encoder 30

Rotation QAM modulator 40

Delay k Q component 50

Symbol interleaver 60

OFDM Modulation 70

10

Channel 80

OFDM Demodulator 90

20

Symbol Deinterleaver 100

Delay k I component and Rotation QAM Demodulator 110

Non binary LDPC decoder 120

DATA

DATA

Fig. 1b

Fig. 1c

START ⌐140

Encode
using non-binary
LDPC ⌐150

Is
Mod.
QAM? ⌐160

STOP ⌐170

no

yes

Rotate
QAM constellation ⌐180

Is
the constellation
sufficiently
rotated? ⌐190

no

yes

Delay Q component
by k ⌐200

Symbol interleave
signal ⌐210

OFDM
modulate ⌐220

Fig. 2

Figure 2 BER performance of the proposed solution systems with different labe링 over different rotation angles at SNR = 12.8 dB, Rayleigh channel

Fig. 3

EP 2 139 139 A1

Fig. 4

Fig. 5

**EUROPEAN SEARCH REPORT**

Application Number

EP 08 30 5343

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NAUMAN F KIYANI ET AL: "Optimized Rotations for LDPC-coded Gray-mapped MPSK Constellations with Signal Space Diversity" PROCEEDINGS OF THE IEEE SYMPOSIUM ON COMMUNICATIONS AND VEHICULAR TECHNOLOGY, 1 November 2006 (2006-11-01), pages 77-80, XP031062927 ISBN: 978-0-7803-9784-2 * section II * * subsection IIIB * * figures 1,2,4 * | 1-14 | INV. H04L1/00 |
| X | Z. MA, Z. SHI, C. ZHOU, Z. ZHANG: "Design of signal space diversity based non-binary LDPC code" PROCEEDINGS OF THE IEEE INTERNATIONAL CONFERENCE ON COMMUNICATIONS, CIRCUITS AND SYSTEMS (ICCCAS), 25 May 2008 (2008-05-25), pages 31-34, XP002510671 * section II * * subsection IIIB * * figure 1 * | 1-14 | |
| X | CONGCHONG RU ET AL: "UEP Video Transmission Based on Dynamic Resource Allocation in MIMO OFDM System" PROCEEDINGS OF THE IEEE WIRELESS COMMUNICATIONS AND NETWORKING CONFERENCE (WCNC), 1 March 2007 (2007-03-01), pages 310-315, XP031097201 ISBN: 978-1-4244-0658-6 * section III * * section IV, paragraph 1 * * figures 1,2,4 * | 1-14 | |

TECHNICAL FIELDS SEARCHED (IPC)

H04L

-/--

The present search report has been drawn up for all claims

| Place of search | Date of completion of the search | Examiner |
|---|---|---|
| The Hague | 19 January 2009 | Anghel, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 08 30 5343

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NAUMAN F KIYANI ET AL: "OFDM with BICM-ID and Rotated MPSK Constellations and Signal Space Diversity" PROCEEDINGS OF THE IEEE SYMPOSIUM ON COMMUNICATIONS AND VEHICULAR TECHNOLOGY, 1 November 2007 (2007-11-01), pages 1-4, XP031205773 ISBN: 978-1-4244-1369-0 * section II * * figure 1 * | 1-14 | |
| X | NAUMAN F KIYANI ET AL: "Optimized Rotations for LDPC-Coded MPSK Constellations with Signal Space Diversity" PROCEEDINGS OF THE IEEE CONFERENCE ON WIRELESS COMMUNICATIONS AND NETWORKING CONFERENCE, 1 March 2007 (2007-03-01), pages 677-681, XP031097268 ISBN: 978-1-4244-0658-6 * section II * * figure 1 * | 1-14 | |
| X | US 2004/086059 A1 (EROZ MUSTAFA [US] ET AL) 6 May 2004 (2004-05-06) * paragraphs [0037] - [0043] * * paragraphs [0104], [0105] * * figures 2A,2B,3,8A,8B * | 1-14 | TECHNICAL FIELDS SEARCHED (IPC) |

The present search report has been drawn up for all claims

| Place of search | Date of completion of the search | Examiner |
|---|---|---|
| The Hague | 19 January 2009 | Anghel, Paul |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

...................................................................................................................

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 08 30 5343

This annex lists the patent family members relating to the patent documents cited in the above-mentioned European search report.
The members are as contained in the European Patent Office EDP file on
The European Patent Office is in no way liable for these particulars which are merely given for the purpose of information.

19-01-2009

| Patent document cited in search report | Publication date | Patent family member(s) | Publication date |
|---|---|---|---|
| US 2004086059 A1 | 06-05-2004 | NONE | |

EPO FORM P0459

For more details about this annex : see Official Journal of the European Patent Office, No. 12/82